# EUROPEAN PATENT APPLICATION

(11) **EP 1 463 380 A1**
(43) Date of publication of application: **29.09.2004**
(21) Application number: 02785994.1
(22) Date of filing: 02.12.2002
(51) Int. Cl.: H05B 3/18, H05B 3/14, H05B 3/20, C04B 35/52, C04B 35/56, H01L 21/02, H01L 21/68, H05B 3/74

(54) **CERAMIC HEATER**

(30) Priority: 30.11.2001 JP 2001367601
(71) Applicant: Ibiden Co., Ltd., Ogaki-shi, Gifu 503-0917 (JP)
(72) Inventor: ITO, Yasutaka, Ibi-gun, Gifu 501-0601 (JP)
(74) Representative: Grünecker, Kinkeldey, Stockmair & Schwanhäusser Anwaltssozietät
(86) International application number: PCT/JP2002/012600
(87) International publication number: WO 2003/047312

(57) **Abstract**

The invention is a ceramic heater provided with a resistor heating body formed in an interior of a ceramic substrate, characterized in that the resistor heating body is made of an electrically conductive ceramic and a sintering aid containing layer is existent at least on the surface of the resistor heating body. This heater does not generate crack even in the rapid temperature rise, and has an effect of uniformizing the heating and rapidly increasing the temperature rising rate, and is used in an industrial field of semiconductor production-inspection apparatuses including an electrostatic chuck or plasma generating device, optical apparatuses and the like.

## Description

### TECHNICAL FIELD

This invention relates to a ceramic heater, and more particularly to a ceramic heater for semiconductor production-inspection devices used in an apparatus for the production and inspection of semiconductor products and a ceramic heater used in the field of optic machines and the like.

### BACKGROUND ART

In the production-inspection device of semiconductor provided with an etching device, a chemical vapor deposition device or the like, there has been used a heater made from a metallic substrate such as stainless steel, aluminum alloy or the like.

In such a metallic heater, however, there is the following problem. Since the heater is made of the metal, the thickness of the heater plate should be made as thick as about 15 mm. Because, the warp, strain or the like is caused in the thin metal plate due to thermal expansion resulted from the heating and hence the silicon wafer placed on the metal plate is broken or inclined. However, as the thickness of the heater plate is made thick, there is a problem that the weight of the heater becomes heavy and bulky.

On the contrary, there has hitherto been proposed a ceramic heater as disclosed in JP-A-9-48668 and the like. This ceramic heater is a heater formed by embedding tungsten in an aluminum nitride substrate. However, since tungsten is a metal and the difference in the thermal expansion coefficient between the ceramic and the metal is large, there is a problem that cracks are apt to be easily caused by rapid rising of the temperature.

Furthermore, JP-A-8-306629, JP-A-11-162620 and JP-A-11-251040 propose a ceramic heater using tungsten carbide, which is a vacuum-forming ceramic having a thermal expansion coefficient relatively near to that of the ceramic, as a resistor heating body.

Also, JP-A-9-40481 discloses a technique wherein a resistor heating body made of a thermal decomposable carbon is formed on a surface of boron nitride and further covered with boron nitride.

In these heaters, however, pores are inevitably produced in an interface between the resistor heating body and the ceramic, so that there is caused a problem that these pores produce a delay in the heat transfer from the resistor heating body to a heating face of the ceramic substrate but also bring about the non-uniform temperature distribution.

The invention is made for solving the above problems and is to provide a ceramic heater wherein the resistor heating body and the ceramic substrate are integrally united with each other without causing cracks in the ceramic substrate even in case of rapidly raising the temperature to thereby hardly cause the temperature difference between the resistor heating body and the heating face of the ceramic substrate and the time delay of the heat transfer.

It is another object of the invention to improve the temperature uniformity of the heating face when an electrically conductive ceramic is used as the resistor heating body.

### DISCLOSURE OF THE INVENTION

The ceramic heater of the invention used in the field of semiconductor production-inspection apparatus or the like is characterized in that a resistor heating body disposed in an interior of the heater is made of an electrically conductive ceramic and a sintering aid containing layer is existent on a surface of the resistor heating body.

In the invention, since the resistor heating body made of the electrically conductive ceramic has the above structure, the thermal expansion coefficient is approximately equal to that of a ceramic substrate, so that even if the rapid rise of the temperature is conducted, no crack is produced in the ceramic substrate. Also, the sintering aid containing layer is adhered to the surface of the resistor heating body, so that the resistor heating body can be integrally united with the ceramic substrate. Therefore, heat on the surface of the resistor heating body cane be efficiently transferred to a heating face of the ceramic substrate and also the temperature difference between the resistor heating body and the heating face of the ceramic substrate is substantially eliminated.

For this end, the temperature of the resistor heating body and the temperature of the heating face of the ceramic substrate can be made substantially the same even in the rapid rise of the temperature.

Further, the resistor heating body according to the invention is preferable to be formed by sintering a green sheet of the electrically conductive ceramic, and also the scattering of the thickness of the resistor heating body is preferable to be within a range of ± 10% of an average thickness. In the invention, when screen printing is conducted for the preparation of the resistor heating body, the scattering of the thickness is caused by the scattering of the printed thickness. Since the electrically conductive ceramic is higher in the volume resistivity (called as a specific resistance) than the metal, the influence of the thickness scattering becomes remarkable. In the invention, therefore, the resistor heating body is formed by using the green sheet of the electrically conductive ceramic and sintering it instead of the printing.

Since the green sheet of the electrically conductive ceramic previously adjusting the thickness scattering to ± 10% is sintered in the invention, the scattering of the thickness is hardly caused different from the case of conducting the printing. For this end, the scattering of resistance value is not caused and the temperature uniformity on the heating face is excellent.

In the invention, a sintering aid containing layer is required to exsist at least on the surface of the electrically conductive ceramic formed by sintering a green sheet.

Hence, as mentioned above, the resistor heating body can be integrally united with the ceramic substrate and heat on the surface of the resistor heating body can be efficiently transferred to the heating face of the ceramic substrate. For the end, the temperature difference is not substantially caused between the resistor heating body and the heating face of the ceramic substrate.

Furthermore, the electrically conductive ceramic is desirable to be at least one selected from electrically conductive carbide or nitride ceramic and carbonaceous material. As the carbide may be used tungsten carbide or molybdenum carbide, and titanium nitride may be used as the nitride.

Among them, the carbonaceous material is most preferable. Because, the tungsten carbide, molybdenum carbide or the like becomes higher in the volume resistivity at a high temperature and decreases the heat generation quantity, but in case of the carbonaceous material, the volume resistivity of the resistor heating body does not make high accompanied with the temperature rise of the resistor heating body and hence the ceramic heater can be heated to a high temperature and heat generation can be sufficiently conducted even at the high temperature. Also,it is not required to change the applied voltage on the way because the volume resistivity of the resistor heating body is not made high accompanied with the temperature rise of the resistor heating body.

In addition, the resistor heating body is disposed in the interior of the ceramic substrate and is not oxidized because it does not directly contact with air, so that there is no change or disappear of the resistance value even when the resistor heating body is heated to a higher temperature.

The sintering aid is desirable to be yttrium oxide or ytterbium oxide. The reason will be described later.

In the ceramic heater, it is desirable that an electrostatic electrode is further formed in the interior of the ceramic substrate and functions as an electrostatic chuck provided with a heater. Because the electrostatic chuck is frequently used for heating a material to be treated such as a semiconductor wafer or the like.

### BRIEF DESCRIPTION OF THE DRAWINGS

FIG. 1 is a plan view diagrammatically illustrating an embodiment of the ceramic heater according to the invention.
FIG. 2 is a partly enlarged section view of the ceramic heater shown in FIG. 1.
FIG. 3 is a section view diagrammatically illustrating a state of disposing the ceramic heater shown in FIG. 1 on a support container.
FIG. 4(a) is a longitudinal section view diagrammatically illustrating an electrostatic chuck as an example of the ceramic heater according to the invention, and FIG. 4(b) is a section view taken along a line A-A.
FIG. 5 is a horizontal section view diagrammatically illustrating another embodiment of an electrostatic electrode embedded in a ceramic substrate.
FIG. 6 is a horizontal section view diagrammatically illustrating the other embodiment of an electrostatic electrode embedded in a ceramic substrate.
FIGS. 7(a)-7(g) are section views diagrammatically illustrating an embodiment of the production method of the ceramic heater according to the invention.
FIGS. 8(a)-8(f) are section views diagrammatically illustrating another embodiment of the production method of the ceramic heater according to the invention.
FIGS. 9(a)-9(g) are flow charts showing the production of a heater provided with a plasma generating electrode according to the invention.
FIG. 10 is a graph showing a temperature raising profile at heating faces of a resistor heating body and a ceramic substrate in the ceramic heater of Example 1.
FIG. 11 is a graph showing a temperature raising profile at heating faces of a resistor heating body and a ceramic substrate in the ceramic heater of Comparative Example 1.
FIG. 12 is a graph showing a temperature raising profile at heating faces of a resistor heating body and a ceramic substrate in the ceramic heater of Example 4.
FIG. 13 is a graph showing a temperature raising profile at heating faces of a resistor heating body and a ceramic substrate in the ceramic heater of Comparative Example 5.
FIG. 14 is an electron microscope photograph of a resistor heating body.
FIG. 15 is a photograph of a heating face in the heater of Example 4 observed by a thermoviewer.
FIG. 16 is a photograph of a heating face in the heater of Comparative Example 5 observed by a thermoviewer.

### BEST MODE FOR CARRYING OUT THE INVENTION

The invention will be described with reference to an embodiment but is not limited to this embodiment.

The invention is a ceramic heater comprising a resistor heating body arranged in an interior of a ceramic substrate and mainly used in the production-inspection apparatus of semiconductors and the like, and is characterized in that the resistor heating body is made of an electrically conductive ceramic and a sintering aid containing layer is existent on the surface of the resistor heating body.

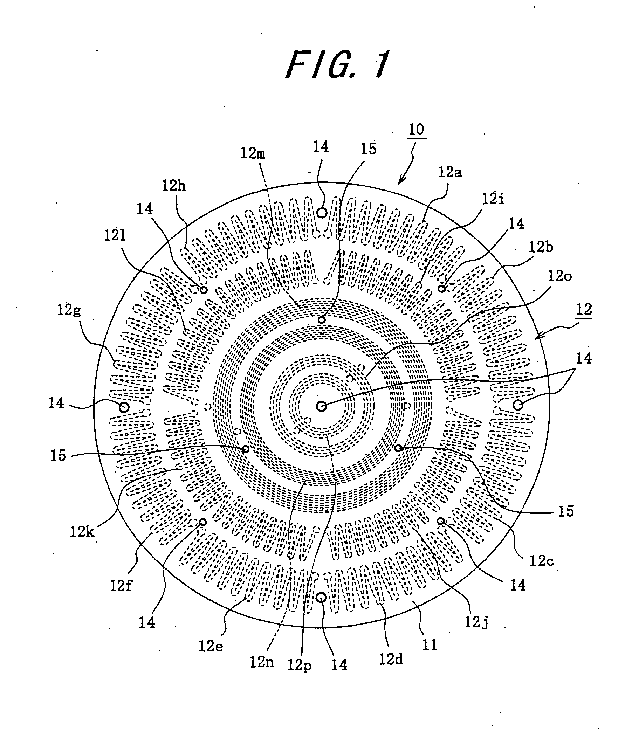

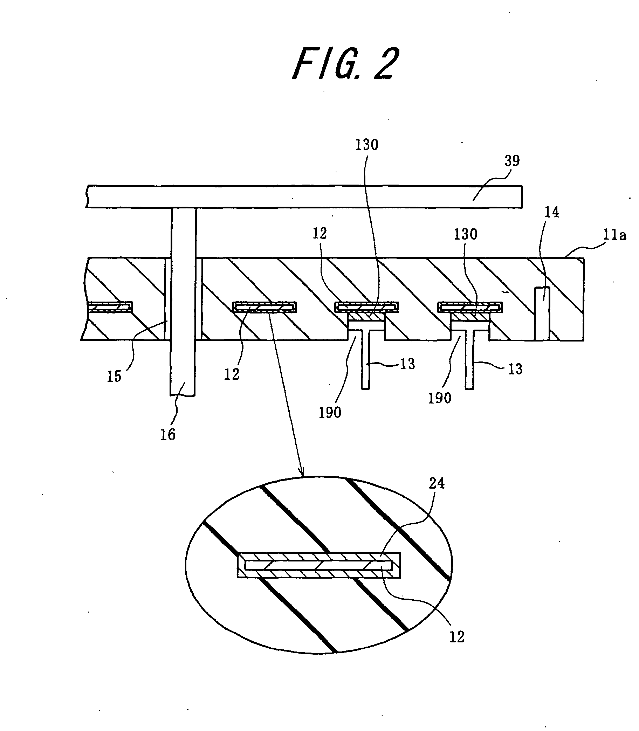

FIG. 1 is a plan view diagrammatically illustrating an embodiment of the ceramic heater according to the invention, and FIG. 2 is a partly enlarged section view of the ceramic heater shown in FIG. 1.

As shown in FIG. 1, in the ceramic heater 10 of the invention, a disc-shaped ceramic substrate 11 is provided in its interior with a resistor heating body 12 comprising resistor heating bodies 12a-12h arranged at a position near to an outer periphery of the substrate and having a pattern of plural repetitive bending curves divided in a peripheral direction, resistor heating bodies 12i-121 arranged inside thereof and having a pattern of similar repetitive bending curves and further resistor heating bodies 12m-12p arranged inside thereof and having concentrically circle forms. To both end portions of these resistor heating bodies 12a-12p are connected external terminals 13 of T-shaped form in section as input and output terminals through through-holes 130.

In a portion of the ceramic substrate 11 near to its center is formed a through-hole 15 for inserting a lifter pin 16, while a bottomed hole 14 for attaching a temperature-measuring element is formed on a bottom surface of the substrate 11.

The lifter pin 16 is such used that a material to be treated such as a semiconductor wafer 39 or the like is placed on the lifter pin 16 and lifted up and down, whereby the semiconductor wafer can be transferred to a transferring machine not shown or the semiconductor wafer can be received from the transferring machine by the action of the lifter pin 16, while the semiconductor wafer is placed on a heating face 11a of the ceramic substrate 11 and heated or the semiconductor wafer is supported at a state of separating from the heating face 11a at a distance of 50-2000 µm and heated.

Also, the heating of the semiconductor wafer can be conducted by forming a through-hole or a depression in the ceramic substrate 11, attaching a support pin having a steeple-shaped or semi-spherical top portion to the through-hole or depression, slightly protruding the support pin from the ceramic substrate 11 to support the semiconductor wafer by the support pin to thereby separate from the heating face by 50-2000 µm.

The resistor heating body 12 used is made of an electrically conductive ceramic such as tungsten carbide, molybdenum carbide, carbonaceous material or the like. The resistor heating body is desirable to be a porous body.

A most important feature of the invention lies in that a sintering aid effectively acting to the firing of a ceramic material constituting the ceramic substrate 11 embedded in the resistor heating body 12 is existent on at least the surface of the resistor heating body 12 through coating or the like.

FIG. 2 is an enlarged section view of the resistor heating body 12. As seen from this figure, a layer of the sintering aid, i.e. a sintering aid-containing layer 24 is formed on an outer peripheral portion of the resistor heating body 12.

By forming the sintering aid containing layer 24 on at least the surface of the resistor heating body 12 (which may be significantly penetrated into the interior), the sintering aid is filled in pores, which are feared in the producing the surface of the resistor heating body 12, through the penetration. In this way, the resistor heating body 12 and the ceramic substrate 11 are structurally united with each other without producing the pores at the interface therebetween. As a result, the thermal conductivity is uniformized in the vicinity of the interface, and also the delay or non-uniformation of the temperature rise can be eliminated between the resistor heating body and the heating face of the ceramic substrate. Therefore, the temperature controlling property of the resistor heating body 12 (responsibility) is improved and the heat transfer from the resistor heating body to the heating face 11a of the ceramic substrate 11 can be rapidly reflected.

As the resistor heating body 12, it is preferable to use a carbonaceous material among the above exemplified materials. The carbonaceous material tends to lower the volume resistivity accompanied with the rise of the temperature, so that the resistor heating body 12 made of such a carbonaceous material does not increase the volume resistivity even if it is heated to a high temperature, and hence it is possible to sufficiently generate heat even at the high temperature and rapidly raise the temperature.

As the carbonaceous material, mention may be made of graphite, glassy carbon, thermally decomposed carbon and so on. They may be used alone or in a combination of two or more.

As the sintering aid, use may be made of alkali metal oxides, alkaline earth metal oxides, oxides of rare earth elements, boron carbide, carbon, sodium oxide, calcium oxide, rubidium oxide, yttrium oxide, ytterbium oxide and so on. An oxygen in the sintering aid may be supplied by the oxide of the rare earth element. Also, such a sintering aid may be applied as a solution to the surface of the electrically conductive ceramic previously shaped into a plate or a foil, or may be mixed in the shaping of the electrically conductive ceramic.

In the invention, a sintered body of a green sheet of an electrically conductive ceramic can be used as the resistor heating body. Since the green sheet of the electrically conductive ceramic is excellent in the uniformity of the thickness, the scattering of the thickness in the resistor heating body formed by the sintering the green sheet can be controlled to a range of ±10%. Therefore, the temperature uniformity of the heating face can be improved.

As a pattern of the resistor heating body 12, mention may be made of a combination of bending curve repeated pattern and a concentric pattern shown in FIG. 1, a combination of eddy form, eccentric form or concentric form and bending curve form, and so on.

In the resistor heating body 12, the resistance value can be changed by varying the thickness or the width, but a range is practically desirable to be 1-5000 µm. Moreover, the resistance value of the resistor heating body 12 becomes large as the thickness becomes thin and the width becomes narrow. For example, the section as the form of the resistor heating body 12 may be either square, ellipsoid, spindle or semicylindrical form, but it is desirable to be flat. In case of the flat form, heat is easily released toward the heating face, so that a heat-transfer quantity to the heating face can be increased and the temperature distribution is hardly produced in the heating face. The resistor heating body 12 may be a spiral form.

In the ceramic heater 10, the number of circuits comprised of the resistor heating body 12 is not particularly limited if it is 1 or more, but it is desirable to form plural divided circuits for uniformly heating the heating face.

When the resistor heating body 12 is embedded in the interior of the ceramic substrate 11, the forming position is not particularly limited, but it is preferable to form at least one layer in a position from a bottom surface of the ceramic substrate 11 up to 60% in a thickness direction thereof. In such an embedding position, heat is easily diffused during the transferring to the heating face 11a and the temperature at the heating face 11a becomes easily uniform.

As a material of the ceramic substrate 11 are mentioned ceramics such as nitride ceramic, carbide ceramic, oxide ceramic and the like. Among them, the nitride ceramic is desirable because it is high in the thermal conductivity. Among the nitride ceramics, aluminum nitride is most preferable because the thermal conductivity is as highest as 180 W/m·K.

The ceramic substrate 11 is desirable to have a brightness of not more than N6 as a value based on the definition of JIS Z8721. The substrate having the above brightness is excellent in the radiant heat quantity and the shielding property. Also, a hot plate constituted with such a ceramic substrate is made possible to conduct an accurate surface-temperature measurement through a thermoviewer.

When an ideal black brightness is 0 and an ideal white brightness is 10, a color between the black brightness and the white brightness is divided into 10 parts so as to render a perception of color brightness into an equal degree, whereby N of the brightness used herein is indicated as symbols of N0-N10. The actual measurement is carried out by comparing with a color atlas corresponding to N0-N10. In this case, one place of decimal is 0 or 5.

The ceramic substrate 11 having such a characteristic is obtained by including 50-5000 ppm of carbon into the substrate. There are amorphous carbon and crystalline carbon. The amorphous carbon can control the lowering of the volume resistivity in the substrate at the high temperature, while the crystalline carbon can control the lowering of the thermal conductivity in the substrate at the high temperature, so that the kind of carbon can be properly selected in accordance with the purpose of the substrate to be produced and the like.

The amorphous carbon can be obtained, for example, by firing a hydrocarbon consisting of C, H and O, preferably saccharides in air, while graphite powder or the like can be used as the crystalline carbon. Also, carbon can be obtained by thermally decomposing an acrylic resin in an inert atmosphere and then heating and pressurizing. In this case, the degree of crystallinity (amorphous property) can be adjusted by changing an acid value of the acrylic resin.

The plane form of the ceramic substrate 11 suitable for the invention is preferable to be a disc form as shown in FIG. 1, a diameter of which is preferable to be not less than 200 mm, and particularly the effect becomes remarkable in the diameter of not less than 250 mm. Although the uniformity of the temperature is required in the disc-shaped ceramic substrate 11, as the diameter of the substrate becomes large, the temperature is apt to become easily non-uniform.

The thickness of the ceramic substrate 11 is preferably not more than 50 mm, more preferably not more than 20 mm. Also, 1-5 mm is optimum. When the thickness is too thin, the warping is easily caused in the heating at the high temperature, while when it is too thick, the heat capacity becomes too large and the temperature raising and descending characteristics lower.

Further, the porosity of the ceramic substrate 11 is preferable to be 0 or not more than 5% for controlling the lowering of the thermal conductivity at the high temperature and the occurrence of warping. The porosity is measured by Archimedes method.

A through-hole 130 is formed just beneath the end portion of the resistor heating body 12. A blind hole 190 is formed between the through-hole 130 and the bottom face of the ceramic substrate 11 so as to lead out the through-hole 130 toward exterior. Into the blind hole 190 is inserted an external terminal 13 and electrically connected to the through-hole 130 through a solder or soldering material (not shown) or the like.

The through-hole 130 is made of a metal such as tungsten, molybdenum or the like, or a carbide thereof, and is desirable to have a diameter of 0.1-10 mm. Because this diameter can prevent the crack or strain while preventing the breakage. The blind hole 190 is not particularly limited in the size, but is sufficient to have a size capable of inserting a head portion of the external terminal 13.

As a material of the external terminal 13, use may be made of a metal such as nickel, coval or the like, and the form thereof is desirable to be a T-shaped form at section. Also, the size is not particularly limited because it is properly adjusted by the size of the ceramic substrate 11, the resistor heating body used or the like, but it is desirable that a diameter of a shaft portion thereof is 0.5-5 mm and a length of the shaft portion is about 1-10 mm. To the external terminal 13 is attached a socket provided with an electrically conductive wire, and such a conductive wire is connected to a power source or the like.

In the bottomed hole 14 is embedded a temperature-measuring element such as a thermocouple provided with a lead wire or the like, which is sealed with a heat-resistant resin, a ceramic (silica gel or the like) or the like. The temperature-measuring element such as thermocouple or the like attached to the bottomed hole 14 is used for measuring the temperature of the resistor heating body 12 and changing a voltage and a current quantity based on the data to control the temperature of the ceramic heater 10 of the invention.

A size of a joint part of the lead wire in the thermocouple is equal to or larger than a filament diameter of the each lead wire and is not more than 0.5 mm. By rendering the lead wire into such a form, a heat capacity is made small in the joint portion of the lead wire, whereby the temperature can be converted into a current value accurately and rapidly. Therefore, the temperature controllability is improved to make small the temperature distribution of the heating face 11a of the semiconductor wafer 39.

As the thermocouple are mentioned K-type, R-type, B-type, E-type, J-type, T-type thermocouples as mentioned in JIS-C-1602 (1980). In addition to the thermocouple, a temperature-measuring element such as platinum temperature-measuring resisting body, thermistor or the like is mentioned as the temperature-measuring means for the ceramic heater 10 of the invention, and also a temperature-measuring means using an optical means such as thermoviewer or the like is mentioned. In case of using the thermoviewer, the temperature of the heating face 11a of the ceramic substrate 11 can be measured, but also the temperature of the surface of the object to be heated such as semiconductor wafer 39 or the like can be directly measured, so that the accuracy of the temperature control of the object to be heated is improved.

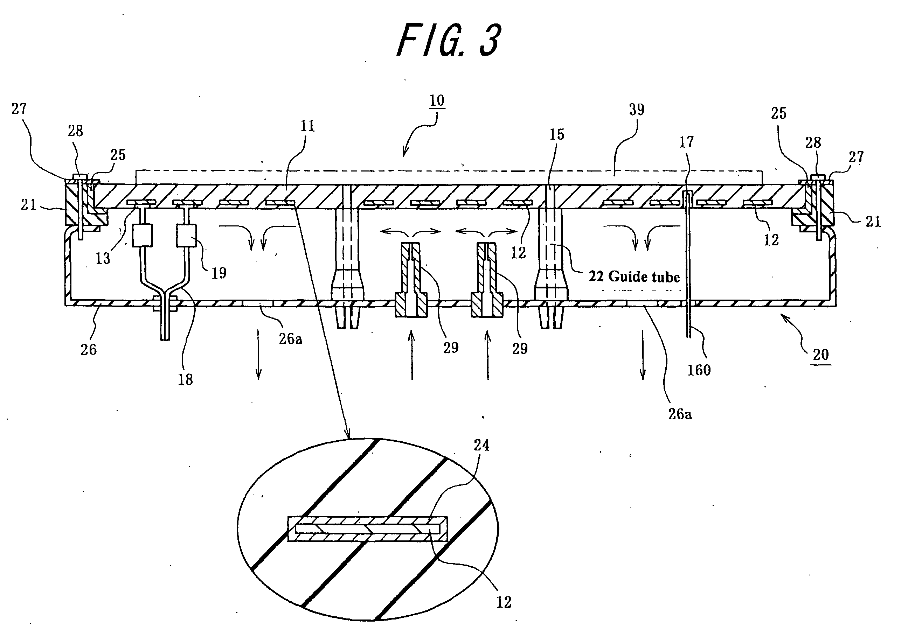

Such a ceramic heater 10 is usually used at a state of arranging on a support container made of a ceramic. FIG. 3 is a section view diagrammatically illustrating the arrangement of the ceramic heater 10 on such a support container. In this figure, the support container 20 is constructed with a heat-shielding member 26 of substantially a bottomed cylindrical form and a support member 21 of a L-shaped form at section placed on an upper part thereof, and a heat-insulating ring 25 of a L-shaped form at section fitted with the ceramic substrate 11 is inserted into the ceramic substrate 21. Also, the ceramic substrate 11 is fixed to the support member 21 and the heat-shielding member 26 with bolts 28 and press fittings 27.

In FIG. 3 is shown an enlarged section view of the resistor heating body 12 formed in the interior of the ceramic substrate 11. As seen from this figure, a sintering aid containing layer 24 is formed on an outer periphery of the resistor heating body 12. Moreover, the indication of the sintering aid containing layer 24 is omitted with respect to the sections of the heating bodies other than the above resistor heating body 12.

In the portion of the ceramic substrate 11 forming the through-hole 15 is arranged a guide tube 22 communicating with the through-hole 15. Also, on the bottom portion of the heat shielding member 26 are arranged plural cooling medium feeding pipes 29 and plural cooling medium discharge ports 26a discharging the cooling medium fed from the cooling medium feeding pipes 29 into the interior of the support container 20 toward exterior., whereby the heated ceramic heater 10 can be rapidly cooled.

In the interior of the support container 20, the external terminal 13 connected to the resistor heating body 12 of the ceramic substrate 11 is connected to an electrically conductive wire 18 through a socket 19. The electrically conductive wire 18 is drawn out from the bottom portion of the heat shielding member 26 toward exterior and connected to a power source or the like not shown. Also, the lead wire 160 connected to the temperature measuring element 17 inserted into the bottomed hole 14 is drawn out from the bottom portion of the heat shielding member 26 and connected to an external control device or the like not shown.

Since the support container 20 having the above structure is not at a state of completely sealing the interior thereof, when an object to be treated such as a silicon wafer 39 or the like is placed on the upper part of the ceramic substrate 11 and a reactive gas or a halogen gas is blown onto the silicon wafer 39, the reactive gas or halogen gas may be penetrated into the interior of the support container 20.

However, the external terminal 13, the electrically conductive wire 18 and the socket 19 are corroded when they are exposed to the reactive gas or halogen gas, so that it is desirable to apply a countermeasure so as not to directly contact the external terminal 13, electrically conductive wire 18 and the socket 19 with the reactive gas or halogen gas.

As the countermeasure, mention may be made of a method of receiving the external terminal 13, electrically conductive wire 18 and the socket 19 in an interior of a cylindrical body.

As a ceramic constituting the cylindrical body, use may be made of aluminum nitride, oxide ceramics such as alumina, silica, mullite, cordierite, and the like, silicon nitride, silicon carbide and so on.

As the other countermeasure, there may be a method of covering the external terminal 13, electrically conductive wire 18 and the socket 19 with a resin having an excellent corrosion resistance or the like.

Further, the lead wire 160 connected to the temperature measuring element 17 is desirable to be received in an interior of a porcelain tube (not shown) so as not to directly contact with the reactive gas, halogen gas or the like. Because it is prevented to corrode the lead wire to cause breakage or the like.

In the ceramic heater 10 arranged in the support container 20 at such a state, therefore, the external terminal 13, electrically conductive wire 18, socket 19 and lead wire 160 are protected by the cylindrical body or porcelain tube of the ceramic or the like, so that even if they are exposed to the reactive gas, halogen gas or the like for a long time, they are not corroded and hence the corrosion resistance becomes excellent.

The ceramic heater 10 of the invention is desirable to be used above 100°C, and more desirable to be used above 200°C. Since the volume resistivity of the resistor. heating body 12 becomes not high at the high-temperature region, the heat generation quantity does not lower even if the applied voltage is not increased, and further the resistance value of the resistor heating body 12 is not changed nor disappeared by oxidation thereof.

The ceramic heater of the invention is an apparatus used for heating the semiconductor wafer or the like in the production and inspection of the semiconductor. Concretely, it is used for placing the object to be treated such as semiconductor wafer or the like on the surface of the ceramic substrate or supporting it separated therefrom and heating to a given temperature or washing.

The ceramic heater of the invention functions as an electrostatic chuck provided with a heater when an electrostatic electrode is further formed in the interior of the ceramic substrate.

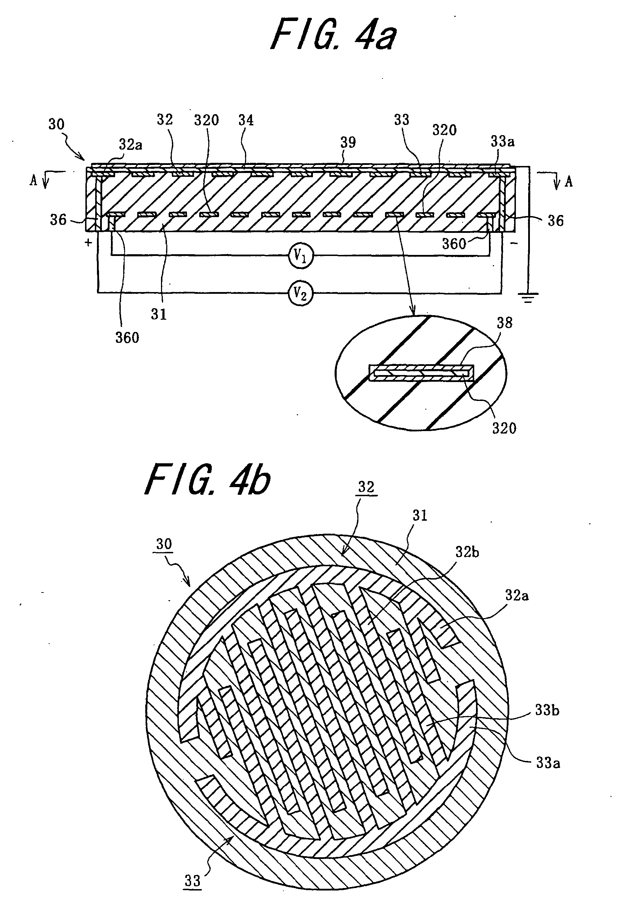

FIG. 4a is a longitudinal section view diagrammatically illustrating such an electrostatic chuck provided with a heater, and FIG. 4(b) is a section view taken along a line A-A.

In the electrostatic chuck 30 provided with the heater, chuck electrostatic positive electrode layer 32 and a chuck electrostatic negative electrode layer 33 are embedded in an interior of a ceramic substrate 31, and through-holes 36 are formed in these chuck electrostatic positive and negative electrode layers 32, 33, and a ceramic dielectric film 34 is formed on these electrostatic electrodes. Also, a resistor heating body 320 is formed in the interior of the ceramic substrate 31 so as to heat an object to be treated such as semiconductor wafer 39 or the like, and an end portion of the resistor heating body 320 is provided with a through-hole 360.

Also, FIG. 4(a) is an enlarged section view of the resistor heating body 320 formed in the interior of the ceramic substrate 31. As seen from this figure, a sintering aid containing layer 38 is formed on a peripheral edge portion of the resistor heating body 320. Moreover, the indication of the sintering aid containing layer 38 is omitted at sections of resistor heating bodies other the resistor heating body 320.

Furthermore, a blind hole not shown is formed in the bottom face of the ceramic substrate 31 so as to expose the through-holes 36, 360, and an external terminal is inserted into the blind hole and may be connected to the through-holes 36, 360 through a solder layer or the like.

In this embodiment, an RF electrode may be embedded in the ceramic substrate 31, if necessary. Furthermore, the resistor heating body 320 in this embodiment can be made of an electrically conductive ceramic such as tungsten carbide, molybdenum carbide, carbonaceous material or the like likewise the resistor heating body 12 of the aforementioned ceramic heater 10. The resistor heating body 320 made of the electrically conductive ceramic is desirable to be a porous body. In addition, at least a surface of the resistor heating body 320 is required to have a layer of a sintering aid effective for sintering the ceramic material of the ceramic substrate 31.

The reason why the sintering aid containing layer is formed on at least a surface of the resistor heating body 320 is the same as mentioned in the aforementioned example of the ceramic heater. Also, it is preferable to use the carbonaceous material as the resistor heating body 320, because the volume resistivity at the high-temperature region becomes not high and hence the heat generation quantity does not lower even if the applied voltage is not increased accompanied with the temperature rise of the resistor heating body 320, and also since the resistor heating body 320 is formed in the interior of the ceramic substrate 31, it does not directly contact with air and hence the resistance value does not change not disappear by oxidation. Therefore, the electrostatic chuck 30 provided with the heater forming the resistor heating body 320 in its interior can be preferably used at the high-temperature region.

As shown in FIG. 4(b), the electrostatic chuck 30 provided with the heater is usually formed in disc form at plane, in which a chuck electrostatic positive electrode layer 32 comprised of a semi-circular portion 32a and comb-shaped portions 32b and a chuck electrostatic negative electrode layer 33 comprised of a semi-circular portion 33a and comb-shaped portions 33b are arranged in the interior of the ceramic substrate 31 so as to intersect these comb-shaped portions 32b, 33b with each other.

The chuck electrostatic positive and negative electrode layers 32, 33 are preferable to be made of a metal such as noble metal (gold, silver, platinum, palladium), lead, tungsten, molybdenum, nickel or the like, or an electrically conductive ceramic such as carbide of tungsten, molybdenum or the like. Also, they may be used alone or in a combination of two or more.

As a material of the ceramic substrate 31 can be used the same material as in the aforementioned ceramic substrate 11 of the ceramic heater 10.

In the bottom face of the ceramic substrate 31 of the electrostatic chuck 30 provided with the heater, the external terminal inserted into the blind hole and connected to the through-hole is connected to an electrically conductive wire through a socket. Further, it is desirable that the heater is subjected to such a countermeasure that the external terminal, socket, electrically conductive wire and the like do not directly contact with the reactive gas or halogen gas likewise the case of the aforementioned ceramic heater 10 and used at a state of arranging on the support container as shown in FIG. 3.

In case of operating the electrostatic chuck 30 provided with the heater, voltages V₁, V₂ are applied to the resistor heating body 320 and the electrostatic electrodes 32, 33, respectively. Thus, the semiconductor wafer 39 placed on the electrostatic chuck 30 provided with the heater is heated to a given temperature and electrostatically absorbed onto the ceramic substrate 31.

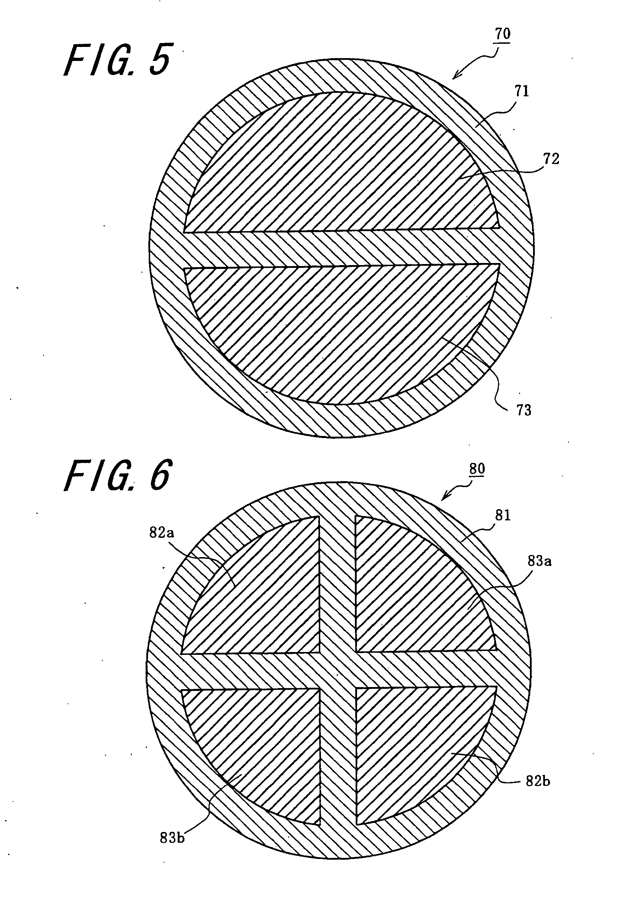

FIG. 5 is a horizontally section view diagrammatically illustrating an electrostatic electrode formed in the ceramic substrate of another electrostatic chuck provided with the heater. As to the electrostatic chuck 70 provided with the heater shown in FIG. 5, semi-circular chuck electrostatic positive electrode layer 72 and chuck electrostatic negative layer 73 are formed in an interior of a ceramic substrate 71. FIG. 6 is a horizontally section view diagrammatically illustrating electrostatic electrodes in the other electrostatic chuck provided with the heater. As to this electrostatic chuck 80 provided with the heater, four-divided chuck electrostatic positive electrode layers 82a, 82b and chuck electrostatic negative electrode layers 83a, 83b are formed in an interior of a ceramic substrate 81. In this case, two chuck electrostatic positive electrode layers 82a, 82b and two chuck electrostatic negative electrode layers 83a, 83b are arranged on a diagonal line so as to cross with each other.

Moreover, when the electrodes are formed in the form of dividing the circle-shaped electrode, the division number is not particularly limited, but 5 or more divisions may be taken, and also the form is not limited to a fan type.

The production method of the ceramic heater according to the invention will be described below.

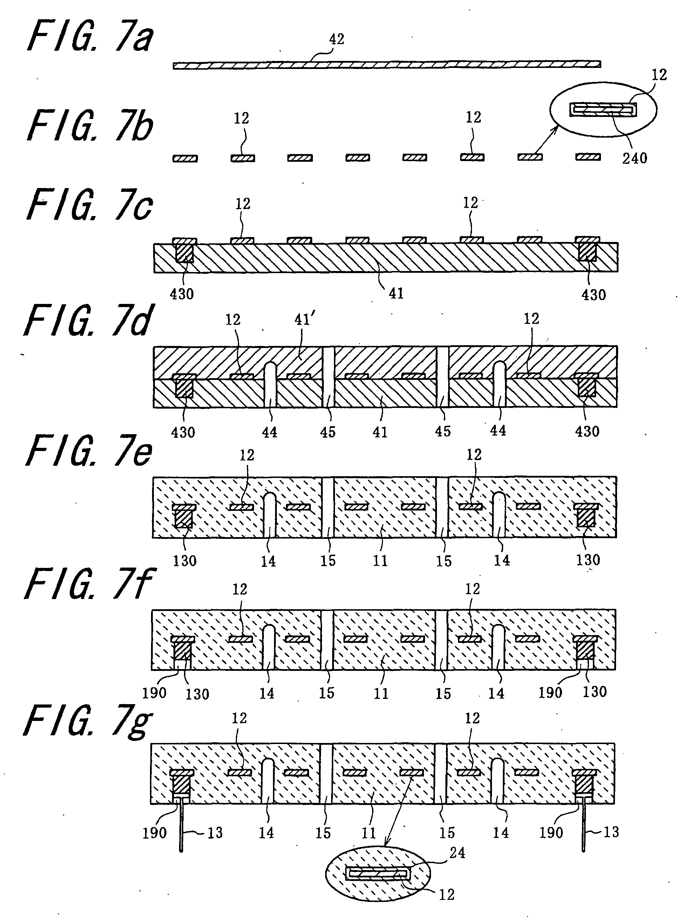

FIGS. 7(a) - (g) are section views diagrammatically illustrating a part of the production method of the ceramic heater according to the invention.

Moreover, an enlarged section view of the resistor heating body 12 is shown in FIGS. 7(b), (g), but the indication of the sintering aid applied layer 240 or sintering aid containing layer 24 is omitted in the section of the resistor heating body other than the above.

### (1) Step of preparing resistor heating body

At first, a carbon sheet 42 is prepared by cutting a carbon block made of the aforementioned carbonaceous material so as to be a thickness of 50-5000 µm (FIG. 7(a)).

Then, a resistor heating body 12 having a pattern as shown in FIG. 1 is prepared by subjecting the carbon sheet 42 to a looter working or the like. Moreover, as the resistor heating body 12, a paste of a mixture of an electrically conductive ceramic such as tungsten carbide, molybdenum carbide or the like and a binder may be shaped into a sheet by a doctor blade process to form a green sheet, which is subjected to a looter working or the like to prepare the resistor heating body 12.

After a solution of the above sintering aid is applied onto the surface of the resistor heating body 12, the sintering aid coated on the surface is penetrated to form a sintering aid coated layer 240 (FIG. 7(b)).

### (2) Step of preparing green sheet

Next, ceramic powder and yttria are mixed with a binder, a solvent and the like, which is subjected to a dry spraying treatment to prepare granules. These granules are shaped by filling in a mold or the like to prepare a green shaped body of a plate shape. In the green shaped body, yttria is desirable to be included in an amount of about 1-10% by weight, and also it is preferable to contain crystalline or amorphous carbon. Also, the green shaped body may contain, for example, CaO, Na₂O, Li₂O, Rb₂O₃ and the like in addition to the yttria. Because these compounds favorably acts as a sintering aid.

As the binder is desirable at least one selected from acrylic binder, ethyl cellulose, butyl cellosolve and polyvinyl alcohol. As the solvent is desirable at least one selected from α-terpineol and glycol.
In the green shaped body is formed a bottomed hole corresponding to a through-hole for connecting an end portion of the resistor heating body to an external terminal, and a conductor paste is filled in the bottomed hole to form a conductor paste layer 430, whereby a green shaped body substrate 41 is prepared. Carbon powders or a molding body thereof may be filled in the bottomed holes. This plate-like green shaped body is preferable to have a thickness of 0.1-5 mm.

In the conductor paste are included metal particles or electrically conductive ceramic particles. The metal particle is preferable to be tungsten particles or molybdenum particles having an average particle size of 0.1-5 µm. When the average particle size is less than 0.1 µm or exceeds 5 µm, it is difficult to print the conductor paste. Moreover, carbide of tungsten or molybdenum and the like can be used as the electrically conductive ceramic particle.

As the conductive paste is preferable a composition (paste) obtained by mixing, for example, 85-87 parts by weight of the metal particles or electrically conductive ceramic particles, 1.5-10 parts by weight of at least one binder selected from acrylic, ethyl cellulose, butyl cellosolve and polyvinyl alcohol, and 1.5-10 parts by weight of at least one solvent selected from α-terpineol and glycol.

### (3) Step of laminating resistor heating body on green sheet

Next, the resistor heating bodies 12 formed into a given pattern are placed on the green shaped body substrate 41 provided with the conductor paste layer 430 corresponding to the through-hole (FIG. 7(c)).

In this case, it is necessary to place the resistor heating body 12 on the green shaped body substrate 41 so as to contact the end portion of the resistor heating body 12 with the filled layer 430 for the through-hole. Because, an external terminal is connected to a through-hole formed later and the resistor heating body 12 is connected to an external power source through the external terminal and the through-hole.

The resistor heating body 12 is desirable to be subjected to a trimming treatment. By this treatment, the resistance value (resistivity) of the resistor heating body 12 can be precisely controlled to make uniform a temperature of a heating face of a ceramic heater to be produced. After a ceramic substrate is formed by firing the green shaped body substrate 41, the resistor heating body 12 may be placed on the substrate.

The trimming treatment can be conducted, for example, by a laser beam or blasting. Even in any method, the resistor heating body 12 can be accurately trimmed and it is possible to precisely control the resistance value (resistivity) of the resistor heating body 12. In the trimming, it is desirable that a resistance-measuring terminal is contacted with carbon of the resistor heating body every a constant distance to measure a resistance value and the trimming is conducted based on the measured results. In the trimming can be used an excimer laser, a carbon dioxide gas laser, a YAG laser and the like.

### (4) Step of printing ceramic paste

Then, a ceramic paste is printed on the green shaped body substrate 41 provided with the resistor heating body 12 by screen printing method or the like to form a ceramic paste layer 41' covering the resistor heating body 12 to thereby prepare a laminate (FIG. 7(d)).

As the ceramic paste, use may be made of a paste having the same composition as the paste used in the preparation of the above green shaped body substrate 41.

Also, it is desirable that the ceramic paste layer 41' is formed by laminating the ceramic paste on the green shaped body substrate 41 through printing plural times. In this case, the thickness of the laminate to be prepared is accurately controlled, while it is prevented to generate the gap between the resistor heating body 12 and the ceramic paste layer 41'.

It is preferable that after the ceramic paste layer printed on the green shaped body substrate 41 is dried, the ceramic paste is printed on the ceramic paste layer again to form the ceramic paste layer 41' having a given thickness.

Also, in the laminate of the ceramic paste are formed a portion 45 corresponding to a through-hole inserting a lifter pin for transferring an object to be treated such as semiconductor wafer or the like, a portion (not shown) corresponding to a through-hole inserting a support pin for supporting the silicon wafer, and a portion 44 corresponding to a bottomed hole for embedding a temperature measuring element such as a thermocouple or the like. Moreover, they may be formed after the above laminate is fired to prepare a ceramic substrate.

### (5) Step of firing ceramic laminate

By heating the laminate are fired the green shaped body substrate 41, the ceramic paste layer 41' and the conductor paste layer 430, which are worked into a given shape to prepare a ceramic substrate 11 forming the resistor heating body 12 and the through-hole 130 therein (FIG. 7(e)).

Since the green shaped body substrate 41 and the ceramic paste layer 41' have the same composition, they are integrally united in the ceramic substrate 11 obtained by firing. The firing of the ceramic laminate may be conducted at a temperature higher than a firing temperature of the ceramic powder. For example, when the ceramic powder is aluminum nitride, the heating temperature is preferable to be 1000-2500°C.

Then, a blind hole 190 is formed by subjecting the bottom face of the ceramic substrate 11 to a drilling or a blasting treatment or the like to exposure the through-hole 130 to an exterior (FIG. 7(f)).

### (6) Attachment of terminal and so on

An external terminal 13 is inserted into the blind hole 190 formed in the bottom face of the ceramic substrate 11 through a solder or a brazing filler metal and then the external terminal 13 is connected to the through-ole 130 by reflowing under heating (FIG. 7(g)).

The heating temperature is preferable to be 90-450°C in case of the solder and 900-1100°C in case of the brazing filler metal.

Then, the external terminal 13 is connected to an electrically conductive wire 18 connected to a power source through a socket 19 (see FIG. 3).

Further, a thermocouple or the like as a temperature measuring element is inserted into the bottomed hole 14 and sealed with a heat-resistant resin or the like to produce a ceramic heater according to the invention.

In the ceramic heater of the invention, the sintering aid containing layer 24 is formed on the outer peripheral portion of the resistor heating body 12 formed in the interior of the ceramic substrate 11 as shown in FIG. 7(g), so that the resistor heating bodies 12 and the ceramic substrate 11 are continuously and integrally united with each other without including pores or the like and hence heat on the surface of the resistor heating body can be rapidly transferred to the heating face of the ceramic substrate. Therefore, it is possible to make the temperature of the resistor heating body approximately equal to a temperature rising rate of the heating face of the ceramic substrate.

In the ceramic heater, the operation such as washing or the like can be conducted while heating or cooling the silicon wafer or the like after the semiconductor wafer such as silicon wafer or the like is placed on the ceramic substrate or the silicon wafer or the like is held by the lifter pin or the support pin.

In the production of the above ceramic heater, an electrostatic chuck can be produced by arranging an electrostatic electrode in the interior of the ceramic substrate. In this case, it is necessary to form a through-hole for connecting the electrostatic electrode to the external terminal, but it is not required to form the through-hole for inserting the support pin.

When the electrode is arranged in the interior of the ceramic substrate, a conductor paste layer corresponding to the electrostatic electrode is formed above the ceramic paste layer printed on the green sheet 41, and further a ceramic paste layer is printed on the conductor paste layer.

As the conductor paste layer may be used the conductor paste used in the formation of the above conductor paste layer 430 corresponding to the through-hole 130.

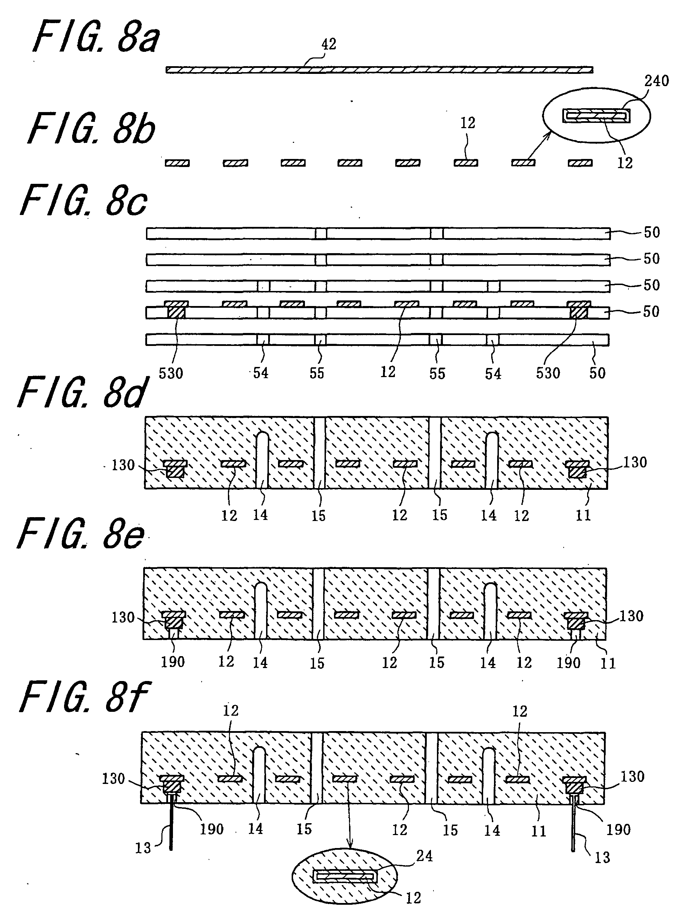

FIGS. 8(a)-(f) are section views diagrammatically illustrating another production method of the ceramic heater according to the invention. Moreover, FIGS. 8(b),(f) shows an enlarged section view of the resistor heating body 12, and the indication of the sintering aid applied layer 240 or the sintering aid containing layer 24 is omitted in the section of the resistor heating body 12 other than the above.

### (1) Step of preparing resistor heating body

At first, a carbon block as a carbonaceous material is cut into a thickness of 0.1-1 mm to prepare a carbon sheet 52 (FIG. 8(a)). Then, the prepared carbon sheet 52 is subjected to a looter working or the like to prepare a resistor heating body 12 having a pattern as shown in FIG. 1.

Moreover, the resistor heating body 12 may be formed by shaping a paste of a mixture of tungsten carbide or molybdenum carbide and a binder into a sheet by a doctor blade process to form a green sheet and subjecting to a looter working or the like.

Furthermore, the above solution of the sintering aid is applied onto the surface of the resistor heating body 12 and penetrated into the surface to form a sintering aid applied layer 240 (FIG. 8(b)).

### (2) Step of preparing green sheet

Ceramic powder and yttria are mixed with a binder, a solvent and the like to prepare a paste, and a green sheet is prepared by using such a paste. In the green sheet, yttria is desirable to be included in an amount of about 0.1-10% by weight. Also, the green sheet may be added with crystalline or amorphous carbon. Further, the green sheet may contain, for example, CaO, Na₂O, Li₂O, Rb₂O₃ and the like in addition to yttria. These compounds favorably acts as a sintering aid.

As the binder is desirable at least one selected from acrylic binder, ethyl cellulose, butyl cellosolve and polyvinyl alcohol.

As the solvent is desirable at least one selected from α-terpineol and glycol.

The thus mixed paste is shaped into a sheet by a doctor blade process to prepare a green sheet 50. The thickness of the green sheet is preferable to be 0.1-5 mm.

In the green sheet are formed a portion corresponding to a through-hole for connecting an end portion of the resistor heating body to an external terminal, a portion 55 corresponding to a through-hole inserting a lifter pin for transferring an object to be treated such as a semiconductor wafer or the like, a portion (not shown) corresponding to a through-hole inserting a support pin for supporting a silicon wafer and a portion 54 corresponding to a bottomed hole for embedding a temperature measuring element such as thermocouple or the like. Moreover, these through-holes and bottomed hole may be formed after the formation of green sheet laminate as mentioned later, or after the above laminate is formed and then fired.

A conductor paste layer 530 is formed by printing a metallic paste or an electrically conductive ceramic paste on the portion corresponding to the through-hole. Such a conductor paste contains metal particles or electrically conductive particles. As the metal particle are preferable tungsten particles, molybdenum particles or the like having an average particle size of 0.1-5 µm. When the average particle size is less than 0.1 µm or exceeds 5 µm, the conductor paste is hardly printed.

Moreover, carbide or the like of tungsten or molybdenum is used as the electrically conductive ceramic particle. As the conductor paste can be used a composition (paste) obtained, for example, by mixing 85-87 parts by weight of metallic particles or electrically conductive ceramic particles, 1.5-10 parts by weight of at least one binder selected from acryl, ethyl cellulose, butyl cellosolve and polyvinyl alcohol, and 1.5-10 parts by weight of at least one solvent selected from α-terpineol and glycol.

### (3) Step of laminating resistor heating body on green sheet

The resistor heating body 12 having a given pattern is placed on the green sheet 50 provided with the conductor paste layer 530 corresponding to the through-hole (FIG. 8(c)).

In this case, it is necessary that the resistor heating body 12 is placed on the green sheet 50 so as to contact the end portion of the resistor heating body 12 with the upper surface of the conductor paste layer 530 corresponding to the through-hole. Because, an external terminal is connected to the though-hole formed as mentioned below and the resistor heating body 12 is connected to an external power source through the external terminal and the through-hole.

The resistor heating body 12 is desirable to be subjected to a trimming treatment. In this case, a resistance value (resistivity) of the resistor heating body 12 can be precisely controlled and a temperature of a heating face in a ceramic heater to be produced can be made uniform.

The trimming treatment can be conducted, for example, by the aforementioned laser beam or blasting. Even in any method, the resistor heating body 12 can be precisely trimmed and it is possible to conduct the accurate control of the resistance value (resistivity) of the resistor heating body 12.

### (4) Step of laminating green sheets

Plural green sheets 50 not provided with the resistor heating body 12 are laminated above and below the green sheet provided with the resistor heating body 12 to prepare a green sheet laminate (FIG. 8(c)). In this case, the number of the green sheets 50 to be laminated above the green sheet provided with the resistor heating body 12 is made larger than the number of the green sheets 50 to be laminated below to displace the forming position of the resistor heating body in the ceramic substrate to be produced toward the bottom face side. Concretely, it is preferable that the lamination number of upper green sheets 50 is 20-50, and the lamination number of the lower green sheets 50 is about 5-20.

### (5) Step of firing green sheet laminate

The green sheet laminate is heated to fire the green sheets 50 and the conductor paste layer 530 arranged therein, which is shaped into a given form to prepare a ceramic substrate 11 embedded with the resistor heating body 12 and the through-hole 130 therein (FIG. 8(d)).

A blind hole 190 is formed by subjecting the bottom face of the ceramic substrate 11 to drilling or blasting treatment such as sand blast or the like to expose the through-hole 130 to exterior (FIG. 8(e)).

### (6) Attachment of terminals and the like

An external terminal 13 is inserted into the blind hole 190 formed in the bottom face of the ceramic substrate 11 through a solder or a brazing metal filler and then the external terminal 13 is connected to the through-hole 130 by reflowing under heating (FIG. 8(f)). The heating temperature is preferable to be 90-450°C in case of the solder and 900-1100°C in case of the brazing metal filler.

Then, the external terminal 13 is connected to an electrically conductive wire 18 connected to a power source through a socket 19 (see FIG. 3). Thereafter, a thermocouple or the like as the temperature measuring element is inserted into the bottomed hole 14 and sealed with a heat-resistant resin or the like to produce a ceramic heater according to the invention.

In the ceramic heater of the invention, the sintering aid containing layer 24 is formed on the outer peripheral portion of the resistor heating body 12 formed in the interior of the ceramic substrate 11 as shown in FIG. 8(f), whereby the resistor heating body 12 and the ceramic substrate 11 are integrally united with each other, so that heat on the surface of the resistor heating body can be transferred to the heating face of the ceramic substrate as it is. Therefore, it is possible to make the temperature of the resistor heating body approximately equal to the temperature of the heating face of the ceramic substrate.

In the ceramic heater, the semiconductor wafer such as silicon wafer or the like is placed on the ceramic substrate or the silicon wafer or the like is held by the lifter pin, support pin or the like, and thereafter the operation such as washing or the like can be conducted while heating or cooling the silicon wafer or the like.

Moreover, in addition to the above method, the ceramic heater according to the invention can be produced by previously preparing the ceramic substrate having through-holes or the like, forming a carbon layer having a given pattern thereon through CVD or the like, further adjusting a resistance value thereof by trimming or the like, covering the resistor heating body with a ceramic paste by the method shown in FIG. 7 and firing them.

In the production of the above ceramic heater, an electrostatic chuck can be produced by arranging electrostatic electrodes in the interior of the ceramic substrate. In this case, however, it is required to form a through-hole for connecting the electrostatic electrode to the external terminal. but it is not required to form a through-hole for inserting the support pin.

When the electrode is arranged in the interior of the ceramic substrate, the electrostatic electrode may be formed by printing a conductor paste layer on the green sheet 50.

As the conductor paste layer, use may be made of the conductor paste layer used in the formation of the conductor paste layer 530 corresponding to the above through-hole 130.

### EXAMPLES

### (Example 1) Production of ceramic heater (see FIGS. 1, 2 and 7)

(1) A carbon sheet 42 is prepared by cutting a carbon block consisting of graphite and glassy carbon (made by IBIDEN Co., Ltd.: T-4/ET-10) into a thickness of 200 µm. The carbon sheet 42 is subjected to a looter working to prepare a resistor heating body 12 having a pattern consisting of bending curve and concentric circles shown in FIG. 1.
   Further, an aqueous solution of 1 mol/l yttrium nitrate is applied and dried on the surface of the resistor heating body 12.
(2) A plate-shaped body having a thickness of 1.5 mm is prepared by subjecting a paste of a mixture of 100 parts by weight of aluminum nitride powder (made by Tokuyama Co., Ltd. average particle size: 1.1 µm), 4 parts by weight of yttrium oxide (Y₂O₃: yttria, average particle size: 0.4 µm), 11.5 parts by weight of acrylic resin binder, 0.5 part by weight of a dispersing agent and 53 parts by weight of an alcohol consisting of 1-butanol and ethanol to a dry spraying treatment and filling the resulting granules in a mold and shaping.
(3) Then, a bottomed hole is formed in a portion of the plate-shaped body corresponding to a through-hole and filled with a conductor paste prepared by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer 430, whereby a green shaped body substrate 41 is prepared.
(4) Then, the resistor heating body 12 prepared at the step (1) is placed on the green shaped body substrate 41 so as to contact the end portion with the conductor paste layer 430 corresponding to the through-hole.
   The resistor heating body 12 is subjected to a laser trimming with a YAG laser having a wavelength of 1060 nm (S143AL made by NEC Corporation, output 5W, pulse frequency 0.1-40 kHz) to control a resistance value (resistivity) thereof. In this case, the resistor heating body is divided into 20 places and the resistance values of these places are measured, and then the trimming treatment is conducted based on the measured results. As a result, the scattering of the resistance value of the resistor heating body 12 is within 5%.
(5) Next, the paste used in the step (2) is printed on the green shaped body substrate 41 provided with the above trimmed resistor heating body 12 by a screen printing process to form a ceramic paste layer 41' having a thickness of 1.5 mm, whereby a laminate is prepared.
   Subsequently, a portion 45 corresponding to a through-hole inserting a lifter pin for transferring a silicon wafer, a portion (not shown) corresponding to a through-hole inserting a support pin for supporting the silicon wafer and a portion 44 corresponding to a bottomed hole for embedding a thermocouple are formed in the above laminate.
(6) The laminate is hot-pressed at 1800°C under a pressure of 20 MPa and cut out in a diameter of 210 mm to obtain an aluminum nitride substrate having a thickness of approximately 3 mm and formed in its interior with the resistor heating body 12 and through-hole 130 but also through-hole 15 and bottomed hole 14.
(7) A blind hole 190 is formed by boring a through-hole 130 formed portion from the bottom face of the aluminum nitride substrate obtained in the step (6).
(8) To the blind hole 190 is attached an external terminal 13 with a silver solder (Ag: 40% by weight, Cu: 30% by weight, Zn: 28% by weight, Ni: 1.8% by weight, remainder: other elements, reflow temperature: 800°C). The, an electrically conductive wire 18 is connected to the external terminal 13 through a socket 19.
(9) A thermocouple for the control of the temperature is inserted into the bottomed hole 14 and filled with a polyimide resin and cured at 190°C for 2 hours to produce a ceramic heater 10 arranged with the resistor heating body and through-hole in its interior.

Moreover, in FIG. 2 is shown an enlarged section view of the resistor heating body 12. As seen from the figure, the sintering aid containing layer 24 is formed on the outer peripheral portion of the resistor heating body 12. Also, the enlarged section of the resistor heating body is shown in FIG. 3, FIG. 4(a), FIGS. 7(b), (g) and FIGS. 8(b), (f). Even in these cases, the sintering aid applied layer or the sintering aid containing layer is formed on the outer peripheral portion of the resistor heating body.

### (Example 2) Production of ceramic heater (see FIGS. 1, 2 and 8)

(1) A carbon block consisting of graphite and glassy carbon (T-4/ET-10, made by IBIDEN CO., Ltd.) is cut in a thickness of 0.6 mm to prepare a carbon sheet 52. This carbon sheet 52 is subjected to a looter working to prepare a resistor heating body 12 having a pattern consisting of bent curve and concentric circles as shown in FIG. 1.
(2) A plurality of green sheets 50 having a thickness of 0.47 mm are prepared by shaping a paste of a mixture of 100 parts by weight of aluminum nitride powder (made by Tokuyama Co., Ltd. average particle size: 1.1 µm), 4 parts by weight of yttrium oxide (Y₂O₃, average particle size: 0.4 µm), 11.5 parts by weight of an acrylic resin binder, 0.5 part by weight of a dispersing agent and 53 parts by weight of an alcohol consisting of 1-butanol and ethanol through a doctor blade process.
   After the green sheet 50 is dried at 80°C for 5 hours, a portion corresponding to a through-hole for connecting to an external terminal through punching, a portion 55 corresponding to a through-hole for inserting a lifter pin for the transfer of a silicon wafer and a portion 54 corresponding to a bottomed hole are formed therein.
(3) Into the portion of the green sheet 50 corresponding to the through-hole is filled a conductor paste prepared by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer 530.
(4) On the green sheet 50 formed with the conductor paste layer 530 corresponding to the through-hole is placed the resistor heating body 12 prepared in the step (1) so as to contact the end portion with the conductor paste layer 530 corresponding to the through-hole.
   The resistor heating body 12 is subjected to a laser trimming with a YAG laser having a wavelength of 1060 nm (S143AL, made by NEC Corporation, output: 5 W, pulse frequency: 0.1-40 kHz) to control a resistance value (resistivity) thereof. In this case, the resistor heating body is divided into 20 places and the resistance values of these places are measured, and then the trimming treatment is conducted based on the measured results. As a result, the scattering of the resistance value of the resistor heating body 12 is within 5%.
(5) Next, 37 green sheets 50 not printed with the conductor paste are laminated on the green sheet 50 placed with the trimmed resistor heating body 12 and 13 green sheets 50 not printed with the conductor paste are laminated therebelow, which are laminated at 130°C under a pressure of 8 MPa to prepare a green sheet laminate.
(6) The laminate is hot-pressed at 1800°C under a pressure of 20 MPa and cut out at a diameter of 210 mm to obtain an aluminum nitride substrate having a thickness of about 3 mm and provided in its interior with the resistor heating body 12 and the through-hole 130 as well as the through-hole 15 and the bottomed hole 14.
(7) Thereafter, a blind hole 190 is formed in the bottom face of the aluminum nitride substrate in the same manner as in the steps (7)-(9) of Example 1 and connected to an external terminal 13 and the like to produce a ceramic heater 10.

### (Example 3) Production of electrostatic chuck (see FIG. 4)

(1) A carbon block consisting of graphite and glassy carbon (T-4/ET-10, made by IBIDEN CO., Ltd.) is cut in a thickness of 0.6 mm to prepare a carbon sheet. This carbon sheet is subjected to a looter working to prepare a resistor heating body 320 having a pattern consisting of bent curve and concentric circles as shown in FIG. 1.
   Further, an aqueous solution of 1 mol/l yttrium nitrate is applied onto the surface of the resistor heating body 320 and dried.
(2) Next, a sheet-shaped body having a thickness of 0.5 mm is prepared by shaping a paste of a mixture of 100 parts by weight of aluminum nitride powder (made by Tokuyama Co., Ltd. average particle size: 1.1 µm), 4 parts by weight of yttrium oxide (Y₂O₃, yttria, average particle size: 0.4 µm), 11.5 parts by weight of an acrylic resin binder, 0.5 part by weight of a dispersing agent and 53 parts by weight of an alcohol consisting of 1-butanol and ethanol through a doctor blade process.
(3) After the sheet-shaped body is dried at 80°C for 5 hours, a bottomed hole is formed in portions corresponding to through-holes 36, 360 and filled with a conductor paste obtained by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer to thereby prepare a green sheet.
(4) On the above green sheet is placed the resistor heating body prepared in the above step (1) so as to contact the end portion thereof with the conductor paste layer corresponding to the through-hole 360.
   The resistor heating body is subjected to a laser trimming with a YAG laser having a wavelength of 1060 nm (S143AL, made by NEC Corporation, output: 5 W, pulse frequency: 0.1-40 kHz) to control a resistance value (resistivity) thereof. In this case, the resistor heating body is divided into 20 places and the resistance values of these places are measured, and then the trimming treatment is conducted based on the measured results. As a result, the scattering of the resistance value of the resistor heating body 12 is within 5%.
(5) On the green sheet placed with the trimmed resistor heating body is printed the paste used in the above step (2) by a screen printing process to form a ceramic paste layer having a thickness of 1.5 mm to thereby form a laminate.
   A through-hole is formed in a portion of the laminate corresponding to the through-hole 36 and filled with the above conductor paste.
(6) An electrostatic electrode pattern shown in FIG. 4(b) is formed on the surface of the laminate by using a conductor paste having the same composition as the conductor paste filled in the portion corresponding to the through-hole, whereby the electrostatic electrode pattern is connected to the conductor paste layer formed in the portion corresponding to the through-hole 36.
   Further, 2 green sheets of 0.47 mm in thickness having the same composition as in the above green sheet not worked are laminated thereon and pressed at 130°C under a pressure of 8 MPa to form a green sheet laminate.
(7) The thus obtained green sheet laminate is hot-pressed at 1800°C under a pressure of 20 MPa and cut out at a diameter of 210 mm to obtain an aluminum nitride substrate having a thickness of approximately 3 mm and provided in its interior with the resistor heating body, through-holes and electrostatic electrodes.
   In the interior of the aluminum nitride substrate are formed the resistor heating body 320 having a thickness of 0.6 mm and a width of 2.4 mm, and chuck positive electrode layer 32 and chuck negative electrode layer 33 having a thickness of 6 µm.
(8) A blind hole is formed on the bottom face of the aluminum nitride substrate obtained in the step (7) by drilling portions formed with the through-holes 36, 360.
(9) An external terminal is attached to the blind hole with a silver solder (Ag: 40% by weight, Cu: 30% by weight, Zn: 28% by weight, Ni: 1.8% by weight, remainder: other elements, reflow temperature: 800°C). Also, an electrically conductive wire is connected to the external terminal through a socket.
(10) A thermocouple for the control of temperature is inserted into the bottomed hole and filled with a polyimide resin and cured at 190°C for 2 hours to produce a ceramic heater provided in its interior with the electrostatic electrodes, resistor heating body and through-holes and functioning as an electrostatic chuck provided with a heater.

### (Example 4) Production of ceramic heater

(1) A sheet-shaped body having a thickness of 50 µm is prepared by shaping a paste obtained by mixing 100 parts by weight of tungsten carbide powder (average particle size: 1.1 µm, 11.5 parts by weight of an acrylic resin binder, 0.5 part by weight of a dispersing agent and 53 parts by weight of an alcohol consisting of 1-butanol and ethanol through a doctor blade process. Then, the sheet -shaped body is punched out into a pattern consisting of bending curves and concentric circles as shown in FIG. 1 to form a resistor heating body. Further, an aqueous solution of 1 mol/l of yttrium nitrate is applied onto the surface of the resistor heating body and dried.
(2) A plate-shaped body having a thickness of 1.5 mm is prepared by subjecting a paste of a mixture of 100 parts by weight of aluminum nitride powder (made by Tokuyama Co., Ltd. average particle size: 1.1 µm), 4 parts by weight of yttrium oxide (Y₂O₃: average particle size 0.4 µm), 11.5 parts by weight of an acrylic resin binder, 0.5 part by weight of a dispersing agent and 53 parts by weight of an alcohol consisting of 1-butanol and ethanol to a dry spraying treatment, and filling and shaping the resulting granulates in a mold.
(3) Then, a bottomed hole is formed in a portion of the plate-shaped body corresponding to a through-hole and filled with a conductor paste prepared by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer 430, whereby a green shaped body substrate 41 is prepared.
(4) On the green shaped body substrate is placed the resistor heating body 12 prepared in the above step (1) so as to contact the end portion with the conductor paste layer corresponding to the through-hole.
   The resistor heating body is subjected to a laser trimming with a YAG laser having a wavelength of 1060 nm (S143AL, made by NEC Corporation, output: 5 W, pulse frequency: 0.1-40 kHz) to control a resistance value (resistivity) thereof. In this case, the resistor heating body is divided into 20 places and the resistance values of these places are measured, and then the trimming treatment is conducted based on the measured results. As a result, the scattering of the resistance value of the resistor heating body 12 is within 5%.
(5) On the green sheet placed with the trimmed resistor heating body 12 is printed the paste used in the above step (2) by a screen printing process to form a ceramic paste layer having a thickness of 1.5 mm to thereby form a laminate.
   In the laminate are formed a portion 45 corresponding to a through-hole inserting a lifter pin for transferring a silicon wafer, a portion (not shown) corresponding to a through-hole inserting a support pin for supporting the silicon wafer and a portion 44 corresponding to a bottomed hole for embedding a thermocouple.
(6) The laminate is hot-pressed at 1800°C under a pressure of 20 MPa and cut out at a diameter of 210 mm to obtain an aluminum nitride substrate having a thickness of approximately 3 mm and provided in its interior with the resistor heating body 12, through-holes 130 and 15 and bottomed hole 14.
(7) A blind hole 190 is formed on the bottom face of the aluminum nitride substrate obtained in the step (6) by drilling the portion formed with the through-holes 130.
(8) An external terminal 13 is attached to the blind hole 190 with a silver solder (Ag: 40% by weight, Cu: 30% by weight, Zn: 28% by weight, Ni: 1.8% by weight, remainder: other elements, reflow temperature: 800°C). Also, an electrically conductive wire 18 is connected to the external terminal 13 through a socket 19.
(9) A thermocouple for the control of temperature is inserted into the bottomed hole 14 and filled with a polyimide resin and cured at 190°C for 2 hours to produce a ceramic heater 10 provided in its interior with the resistor heating body and through-holes.

### (Example 5) Production of ceramic heater

(1) A sheet-shaped body having a thickness of 50 µm is prepared by shaping a paste of a mixture of 100 parts by weight of molybdenum carbide powder (average particle size: 1.1 µm), 11.5 parts by weight of an acrylic resin binder, 0.5 part by weight of a dispersing agent and 53 parts by weight of an alcohol consisting of 1-butanol and ethanol through a doctor blade process. Then, the sheet-shaped body is subjected to punching into a pattern as shown in FIG. 1.

Further, a ceramic heater is prepared in the same manner as in Example 4 except that an aqueous solution of 1 mol/l of yttrium nitrate is applied to the surface of the resistor heating body and dried.

### (Example 6) Production of ceramic heater provided with a plasma generating electrode

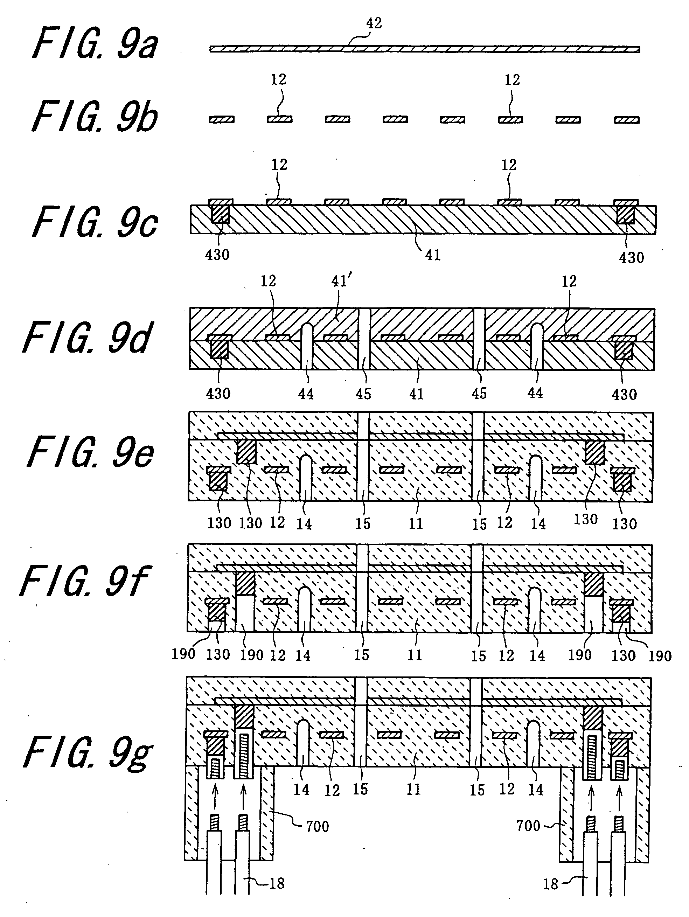

(1) A sheet-shaped body having a thickness of 50 µm is prepared by shaping a paste of a mixture of 100 parts by weight of molybdenum carbide powder (average particle size: 1.1 µm), 11.5 parts by weight of an acrylic resin binder, 0.5 part by weight of a dispersing agent and 53 parts by weight of an alcohol consisting of 1-butanol and ethanol through a doctor blade process. Then, the sheet-shaped body is punched out into a pattern consisting of bending curves and concentric circles as shown in FIG. 1 to form a resistor heating body (FIGS. 9(a), (B)).
(2) A plate-shaped body having a thickness of 1.5 mm is prepared by subjecting a paste of a mixture of 100 parts by weight of aluminum nitride powder (made by Tokuyama Co., Ltd. average particle size: 1.1 µm), 4 parts by weight of yttrium oxide (Y₂O₃: average particle size 0.4 µm), 11.5 parts by weight of an acrylic resin binder, 0.5 part by weight of a dispersing agent and 53 parts by weight of an alcohol consisting of 1-butanol and ethanol to a dry spraying treatment, and filling and shaping the resulting granulates in a mold.
(3) Then, a bottomed hole is formed in a portion of the plate-shaped body corresponding to a through-hole and filled with a conductor paste prepared by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer 430, whereby a green shaped body substrate 41 is prepared.
(4) On the green shaped body substrate is placed the resistor heating body 12 prepared in the above step (1) so as to contact the end portion with the conductor paste layer corresponding to the through-hole (FIG. 9(c)).
   The resistor heating body is subjected to a laser trimming with a YAG laser having a wavelength of 1060 nm (S143AL, made by NEC Corporation, output: 5 W, pulse frequency: 0.1-40 kHz) to control a resistance value (resistivity) thereof. In this case, the resistor heating body is divided into 20 places and the resistance values of these places are measured, and then the trimming treatment is conducted based on the measured results. As a result, the scattering of the resistance value of the resistor heating body 12 is within 5%. To the resistor heating body is applied an aqueous solution of 1 mol/l yttrium nitrate.
(5) On the green shaped body substrate 41 placed with the trimmed resistor heating body 12 is printed the paste used in the above step (2) by a screen printing process to form a ceramic paste layer having a thickness of 1.5 mm to thereby form a laminate (FIG. 9(d)).
   In the laminate is formed an opening for a through-hole (pad for current supply terminal). Further, a conductor paste prepared by mixing 100 parts by weight of tungsten particles having an average particle size of 1 µm, 3.0 parts by weight of an acrylic binder, 3.5 parts by weight of α-terpineol solvent and 0.3 parts by weight of a dispersing agent is printed thereon and the paste used in the above step (2) is printed thereon through a screen printing process to form a high frequency electrode 500 and a through-hole (pad) 130 connecting a terminal for supplying power to the high frequency electrode. On the high frequency electrode 500 is formed a ceramic paste layer having a thickness of 1.5 mm to prepare a laminate.
   In the laminate are formed a portion 45 corresponding to a through-hole inserting a lifter pin for transferring a silicon wafer, a portion (not shown) corresponding to a through-hole inserting a support pin for supporting the silicon wafer and a portion 44 corresponding to a bottomed hole for embedding a thermocouple (FIG. 9(e)).
(6) The laminate is hot-pressed at 1800°C under a pressure of 20 MPa and cut out at a diameter of 210 mm to obtain an aluminum nitride substrate having a thickness of approximately 3 mm and provided in its interior with the resistor heating body 12, high frequency electrode 500, through-holes 130 and 15 and bottomed hole 14.
(7) A blind hole 190 is formed on the bottom face of the aluminum nitride substrate obtained in the step (6) by drilling the portion formed with the through-holes 130 (FIG. 9(f)).
(8) An ALN cylinder having an inner diameter of 5 mm and a diameter of 6 mm is shaped by subjecting a paste of a mixture of 100 parts by weight of aluminum nitride powder (made by Tokuyama Co., Ltd. average particle size: 1.1 µm), 11.5 parts by weight of an acrylic resin binder, 0.5 part by weight of a dispersing agent and 53 parts by weight of an alcohol consisting of 1-butanol and ethanol to a dry spraying treatment and filling and shaping the resulting AlN granules not added with yttria in a mold, which is sintered at 1800°C under an atmospheric pressure to form a protection tube 700.
(9) An external terminal 13 is attached to the blind hole 190 with a silver solder (Ag: 40% by weight, Cu: 30% by weight, Zn: 28% by weight, Ni: 1.8% by weight, remainder: other elements, reflow temperature: 800°C). A female thread is formed in an interior of the external terminal 13 and a power supply rod is connected to the female thread.
(10) The protection tube 700 is contacted with the ceramic substrate and fired at 1850°C for 1 hour to join the protection tube to the ceramic substrate (FIG. 9(g)).
(11) A sheath thermocouple for the control of temperature is inserted into the bottomed hole 14 to produce a ceramic heater 10 provided in its interior with the resistor heating body and through-holes (pad) and high frequency electrode.

### (Comparative Example 1) Production of ceramic heater

A ceramic heater is produced in the same manner as in Example 1 except that the aqueous solution of yttrium nitrate is not applied onto the surface of the resistor heating body 12 at the step (1) of Example 1.

### (Comparative Example 2) Production of ceramic heater

A ceramic heater is produced in the same manner as in Example 1 except that a heating wire made of tungsten having a diameter of 0.5 mm is used as a resistor heating body instead of the resistor heating body prepared by working the carbon sheet.

### (Comparative Example 3) Production of ceramic heater

(1) A plate-shaped body having a thickness of 1.5 mm is prepared by subjecting a paste of a mixture of 100 parts by weight of aluminum nitride powder (made by Tokuyama Co., Ltd. average particle size: 1.1 µm), 4 parts by weight of yttrium oxide (Y₂O₃: average particle size: 0.4 µm), 11.5 parts by weight of an acrylic resin binder, 0.5 part by weight of a dispersing agent and 53 parts by weight of an alcohol consisting of 1-butanol and ethanol to a dry spraying treatment and filling and shaping the resulting granules in a mold.
(2) In the plate-shaped body is formed a bottomed hole corresponding to a through-hole and filled with a conductor paste prepared by mixing 100 parts by weight of tungsten carbide particles having an average particle size of 1 µm, 3.0 parts by weight of an acrylic binder, 3.5 parts by weight of α-terpineol solvent and 0.3 part by weight of a dispersing agent to form a conductor paste layer, whereby a green shaped body substrate is prepared.
(3) Then, a plate-shaped body of aluminum nitride having an opening of a pattern similar to that of the resistor heating body shown in FIG. 1 is placed on the green shaped body substrate and methane gas is thermally decomposed under conditions of 1800°C and 400 Pa (3 Torr) to form a thermal decomposed carbon layer on the surface of the green shaped body substrate, and thereafter the plate-shaped body of aluminum nitride is taken out to form a resistor heating body having a pattern consisting of bending curves and concentric circles on the green shaped body substrate.
(4) A ceramic paste layer having a thickness of 1.5 mm is formed on the green shaped body substrate to prepare a laminate.
   Then, a portion corresponding to a through-hole inserting a lifter pin for transferring a silicon wafer, a portion (not shown) corresponding to a through-hole inserting a support pin for supporting the silicon wafer and a portion corresponding to a bottomed hole for embedding a thermocouple are formed in the laminate.
(5) The laminate is hot pressed at 1800°C under a pressure of 20 MPa and cut out at a diameter of 210 mm to obtain aluminum nitride substrate having a thickness of approximately 3 mm and provided in its interior with the resistor heating body of graphite formed by thermal decomposition of methane gas, through-holes, and bottomed hole.
(6) A blind hole is formed on the bottom face of the aluminum nitride substrate obtained in the step (5) by drilling a portion formed with the through-hole.
(7) To the blind hole is attached an external terminal with a silver solder (Ag: 40% by weight, Cu: 30% by weight, Zn: 28% by weight, Ni: 1.8% by weight, remainder: other elements, reflow temperature: 800°C). Then, an electrically conductive wire is connected to the external terminal through a socket.
(8) A thermocouple for the control of the temperature is inserted into the bottomed hole, and filled with silica sol and cured at 400°C for 2 hours to produce a ceramic heater provided in its interior with the resistor heating body and through-holes.

### (Comparative Example 4)

The same procedure as in Example 4 is basically repeated except that a conductor paste prepared by mixing 100 parts by weight of tungsten carbide particles having an average particle of 1 µm, 3.0 parts by weight of an acrylic binder, 3.5 parts by weight of α-terpineol solvent and 0.3 part by weight of a dispersing agent is screen-printed instead of using a green sheet of tungsten carbide.

### (Comparative Example 5) Production of ceramic heater

A sheet-shaped body having a thickness of 50 µm is prepared by shaping a paste of a mixture of 100 parts by weight of tungsten carbide powder (average particle size: 1.1 µm), 11.5 parts by weight of an acrylic resin binder, 0.5 part by weight of a dispersing agent and 53 parts by weight of an alcohol consisting of 1-butanol and ethanol through a doctor blade process. The sheet-shaped body is punched out into a pattern consisting of bending curves and concentric circles as shown in FIG. 1 to form a resistor heating body. The surface of the resistor heating body is not applied with the aqueous solution of 1 mol/l of yttrium nitrate. A ceramic heater is produced in the same manner as in Example 4 other than the above.

With respect to the ceramic heaters of Examples 1-6 and Comparative Examples 1-5 are measured values of resistances at 25°C and 400°C of the resistor heating body and examined the presence or absence of crack when the temperature of the ceramic heater is raised from 25°C to 400°C for 30 seconds. These results are shown in Table 1.

**[Table 1]**

| | Scattering of thickness of resistor body% | Temperature difference of heating face °C | Time up to steady state (sec) | Resistance value (Ω) | | Crack |
|---|---|---|---|---|---|---|
| | | | | 25°C | 400°C | |
| Example 1 | 3 | 3 | 190 | 9.5×10⁻³ | 6.8×10⁻³ | absence |
| Example 2 | 5 | 2 | 185 | 10.1×10⁻³ | 7.8×10⁻³ | absence |
| Example 3 | 8 | 2 | 191 | 9.8×10⁻³ | 7.1×10⁻³ | absence |
| Example 4 | 6 | 4 | 200 | 0.63 | 1.8 | absence |
| Example 5 | 10 | 3.5 | 200 | 0.72 | 2.1 | absence |
| Example6 | 6 | 3.8 | 200 | 0.65 | 1.9 | absence |
| Comparative Example 1 | 3 | 7 | 240 | 9.3×10⁻³ | 6.5×10⁻³ | presence |
| Comparative Example 2 | - | 8 | 300 | 0.2 | 0.6 | presence |
| Comparative Example 3 | 22 | 10 | 310 | 20.1×10⁻³ | 18.2×10⁻³ | presence |
| Comparative Example 4 | 15 | 7 | 340 | 0.65 | 1.9 | presence |
| Comparative Example 5 | 6 | 7 | 250 | 0.70 | 2.2 | presence |

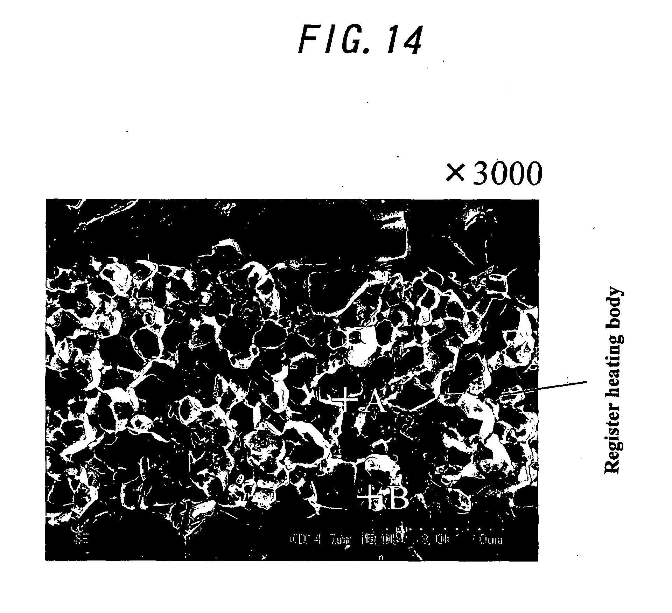

FIG. 14 is an electron microphotograph of a resistor heating body made of tungsten carbide. Also, "+A" and "+B" in the figure are points conducting the measurement through an energy dispersion type fluorescent X-ray analysis device (EPMA). At the point A is not detected Y, but Y is detected at the point B. It is guessed that the binding between the resistor heating body and ceramic is promoted by yttria.

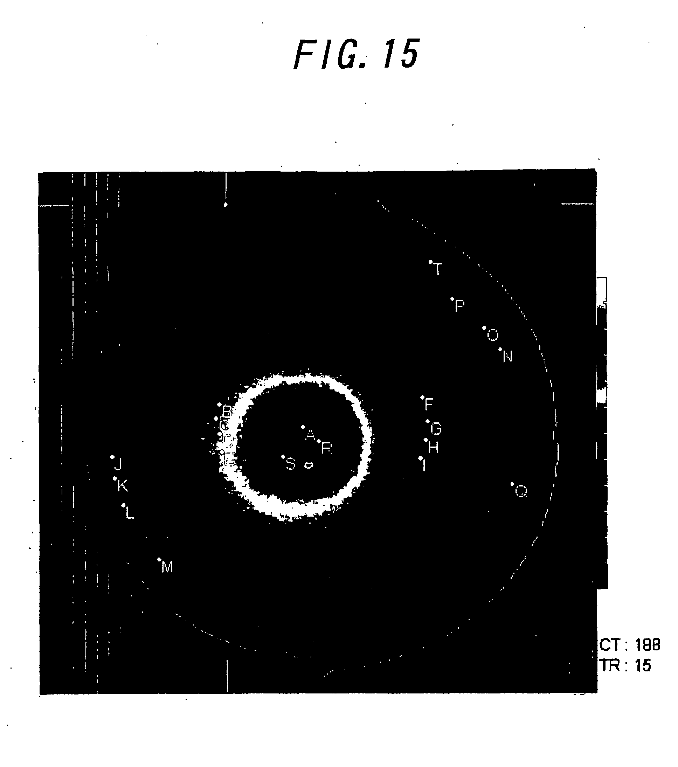

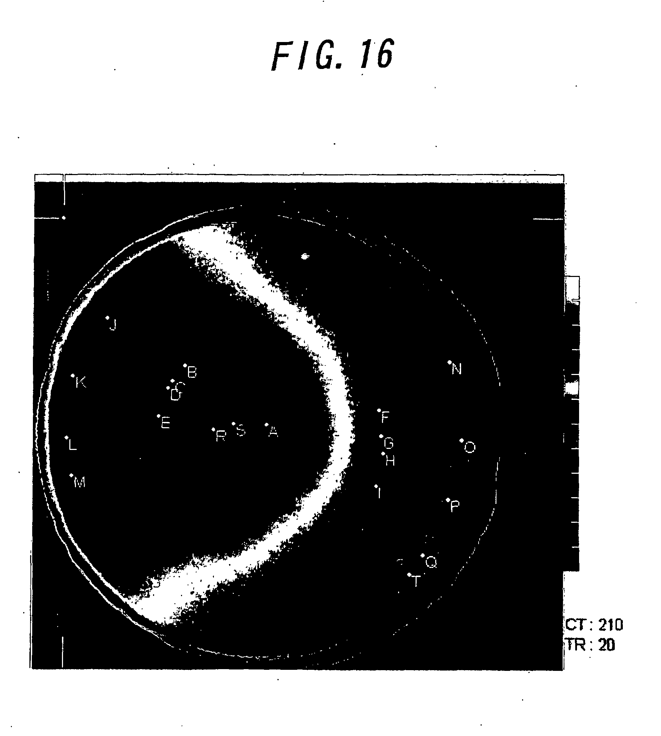

FIGS. 15 and 16 are photographs through a thermoviewer showing a temperature distribution of a heating face when a heater of Example 4 and a heater of Comparative Example 5 are set to a steady state of 450°C, respectively. In the heater of Example 4, the temperature difference of the heating face is small.

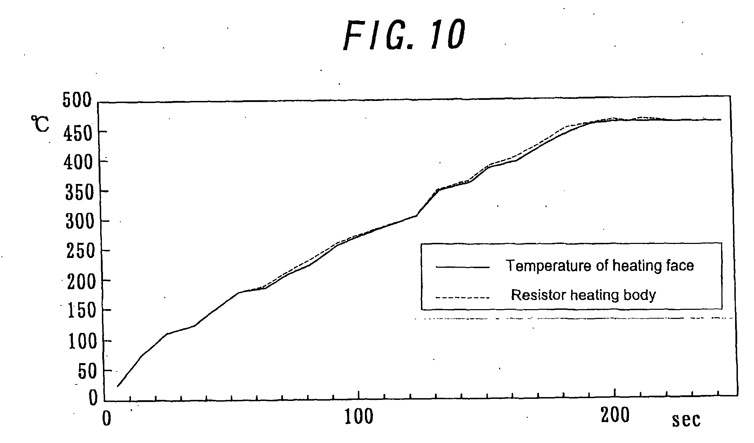

With respect to the ceramic heaters of Examples 1, 4 and Comparative Examples 1, 5, a state of raising temperature of the resistor heating body and the heating face of the ceramic substrate when a power is supplied to the ceramic heater is shown in FIGS. 10 to 13, respectively. Moreover, the heating face in the figures means the heating face of the ceramic substrate.

The state of raising the temperature of the heating face is observed by using a thermoviewer (made by Nippon Datum Co., Ltd. IR-162012-0012). Also, the temperature of the resistor heating body is measured by forming an opening having a diameter of 5 mm in the ceramic substrate through a counter sunk working and inserting a sheath thermocouple provided with an insulating protection tube thereinto. Furthermore, the scattering of the thickness in the resistor heating body is evaluated by cutting the ceramic heater with 4 line segments passing through a center of the ceramic substrate, measuring the thickness appearing at each cut section and averaging these thicknesses as an average thickness and dividing a difference between maximum value and minimum value of the thicknesses appearing at cut sections by the average thickness on percentage.

The resistance value of the heating body is determined by measuring a resistance between 10 mm of the heating body produced by the same method as in the examples through a tester.

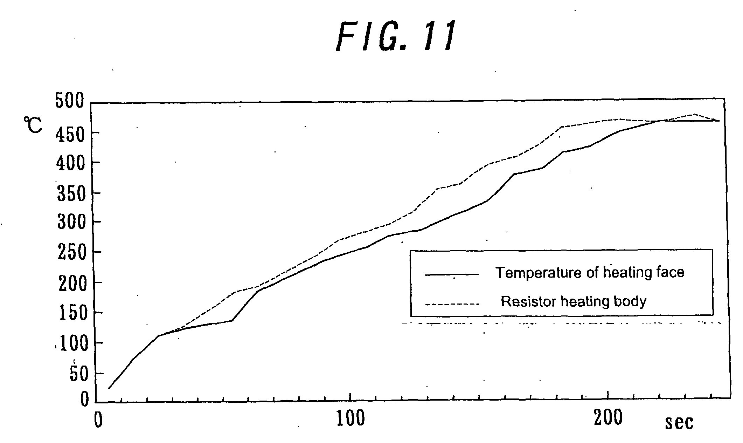

In FIGS. 10 and 11 are shown ceramic heaters using the resistor heating bodies of Example 1 and Comparative Example 1. In these ceramic heaters, it is understood that the difference of the time for raising temperature is small between the resistor heating body and the heating face of the ceramic substrate.

It can be seen from Example 1 that there is substantially no temperature difference between the resistor heating body and the ceramic heating face and the temperature controllability of the heating face is excellent even in the temperature rise at a high speed.

On the contrary, the temperature difference between the resistor heating body and the heating face at a high-temperature region is large in Comparative Example 1 and the followability is poor. This is considered due to the fact that micro-pores are existent at the boundary between the resistor heating body and the matrix of the ceramic substrate.

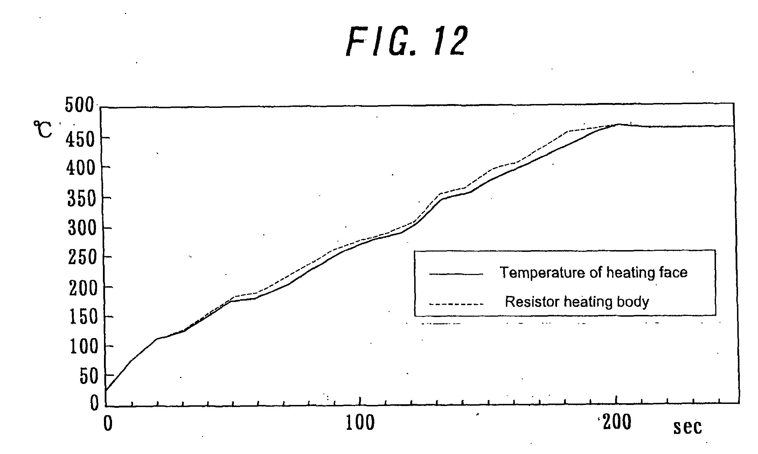

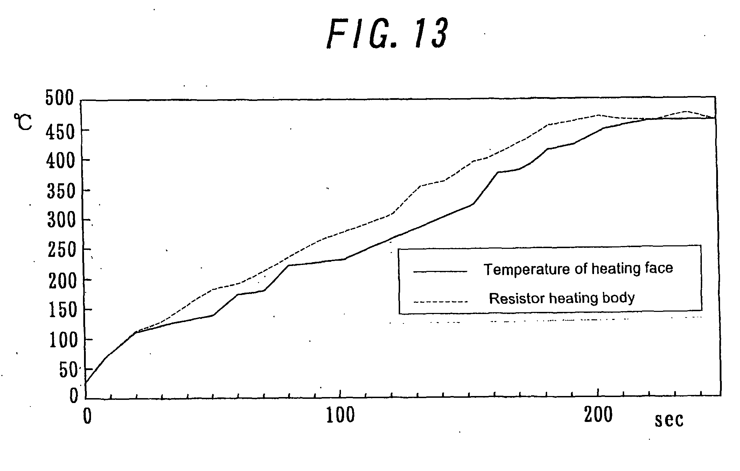

In FIGS. 12 and 13 are shown ceramic heaters using the resistor heating bodies of Example 4 and Comparative Example 5, respectively.

It can be seen from Example 4 that there is substantially no temperature difference between the resistor heating body and the ceramic heating face and the temperature controllability of the heating face is excellent even in the temperature rise at a high speed.

On the contrary, the temperature difference between the resistor heating body and the heating face at a high-temperature region is large in Comparative Example 5 and the followability is poor. This is considered due to the fact that micro-pores are existent at the boundary between the resistor heating body and the matrix of the ceramic substrate.

In Examples 1 to 6, the time arriving at the steady temperature (450°C) is not more than 200 seconds, while it exceeds 200 seconds in Comparative Examples 1, 5.

From the comparison between Examples 1 and 4, the behavior at the high temperature is superior in the carbon heating body to the carbide ceramic sintered body.

Even if the scattering of the thickness of the resistor heating body is not more than 10%, the scattering of the heating face temperature is smaller in the examples. This can be understood from the comparison between Example 4 and Comparative Example 5. Although the scattering of the thickness is 6% in Example 4 and Comparative Example 5, the temperature difference of the heating face becomes small in Example 4. Because, in case of Comparative Example 5, it is considered that a higher portion and a lower portion of the existing density of micro-pores are existent between the resistor heating body and the ceramic.

Thus, in the ceramic heater using the resistor heating body made of tungsten carbide or molybdenum carbide, the resistance value at the high temperature region rises and the time required for raising temperature is long, but the difference in the temperature rising time between the resistor heating body and the heating face of the ceramic substrate is small.

In the ceramic heater of Comparative Example 3, the temperature rising time difference between the resistor heating body and the heating face of the ceramic substrate is large and the time reaching to the steady state becomes long.

In the ceramic heater of Comparative Example 2, since the heat generating wire of tungsten is used, a long time for raising temperature of the heating face of the ceramic substrate is taken.

In Comparative Example 4, the resistor heating body made of tungsten carbide is formed by the screen printing process, so that the scattering of the thickness becomes large and the temperature difference of the heating face becomes large.

In Examples 1 to 6, crack is not generated in the temperature rise at a high speed (400°C for 30 seconds), while crack is generated in Comparative Examples 1 to 5. Since the temperature rising profile of the resistor heating body is same, it is considered that the temperature rising profile of the ceramic is largely shifted from that of the resistor heating body in the comparative examples and the thermal expansion of the resistor heating body is larger than that of the ceramic and hence cracks are generated in the ceramic.

As seen from the above explanation and the results of the examples, in the ceramic heater of the invention, the resistor heating body formed in the interior is made of the electrically conductive ceramic and the sintering aid containing layer existent at least on the surface of the resistor heating body, so that the temperature of the heating face of the ceramic substrate follows to the temperature rise of the resistor heating body and the shift of the temperature rising time therebetween is less. Also, there is not generated cracks even in the case of conducting rapid temperature rise. Further, the carbonaceous material is used as the electrically conductive ceramic, so that the volume resistivity of the resistor heating body is never increased at the high temperature region and the heat generation quantity can be sufficiently ensured. Moreover, the temperature uniformity of the heating face at the steady state is excellent.

As to the thickness of the sintering aid layer, in Example 1 the thickness of the resistor heating body after the sintering is 180 µm and the sintering aid layer is 55 µmm, and in Example 2 the thickness of the resistor heating body after the sintering is 540 µm and the sintering aid layer is 162 µmm, and in Example 3 the thickness of the resistor heating body after the sintering is 540 µm and the sintering aid layer is 190 µmm, and in Example 4 the thickness of the resistor heating body after the sintering is 20 µm and the sintering aid layer is 1 µmm, and in Example 5 the thickness of the resistor heating body after the sintering is 20 µm and the sintering aid layer is 2 µmm, and in Example 6 the thickness of the resistor heating body after the sintering is 20 µm and the sintering aid layer is 3 µmm. Although the sintering aid layer is considered to be about 5% to 35% of the thickness of the heating body, it is anticipated that the effect of the invention is developed when the thickness of the heating body is within a range of 0.1-40%.

### INDUSTRIAL APPLICABILITY

The ceramic heater of the invention can be used in various semiconductor production-inspection apparatuses such as drying device of resist, plasma CVD device, plasma etching device, sputtering device, wafer prober and the like. Also, it can be used in the field of optical devices. In the application to the field of the optical apparatus, a wave guide of quartz can be formed in the heating face of the ceramic substrate.

## Claims

1. A ceramic heater **characterized in that** a resistor heating body disposed in an interior of a ceramic substrate is made of an electrically conductive ceramic and a sintering aid containing layer is existent on a surface of the resistor heating body.

2. A ceramic heater according to claim 1, wherein the electrically conductive ceramic is at least one selected from a carbonaceous material or an electrically conductive carbide ceramic or nitride ceramic.

3. A ceramic heater according to claim 1 or 2, wherein the sintering aid is yttrium oxide or ytterbium oxide.

4. A ceramic heater according to any one of claims 1 to 3, wherein an electrostatic electrode is arranged in an interior of the ceramic substrate to use as an electrostatic chuck provided with a heater.

5. A ceramic heater according to any one of claims 1 to 4, wherein a high frequency electrode is further arranged in an interior of the ceramic substrate to use as a plasma generating device.

6. A ceramic heater according to any one of claims 1 to 5, wherein the resistor heating body is formed by sintering a green sheet of the electrically conductive ceramic.

7. A ceramic heater according to any one of claims 1 to 6, wherein a scattering of a thickness in the resistor heating body is within a range of ± 10% of an average thickness.
